# EUROPÄISCHE PATENTSCHRIFT

(11) **EP 0 618 502 B1**
(45) Veröffentlichungstag und Bekanntmachung des Hinweises auf die Patenterteilung: **03.12.1997**
(21) Anmeldenummer: 94101765.9
(22) Anmeldetag: 05.02.1994
(51) Int. Cl.: G03F 7/00

(54) **Verfahren zum Herstellen gestufter Formeinsätze, gestufte Formeinsätze und damit abgeformte gestufte Mikrostrukturkörper hoher Präzision**
Process for making stepped moulds, stepped moulds and high precision stepped microstructure bodies moulded therewith
Procédé pour la fabrication de garnitures de moulage étagées; garnitures de moulage étagées ainsi que des microstructures à haute précision réalisées à partir de ces moules

(30) Priorität: 30.03.1993 DE 4310296
(43) Veröffentlichungstag der Anmeldung: 05.10.1994
(73) Patentinhaber: MICROPARTS GESELLSCHAFT FÜR MIKROSTRUKTURTECHNIK mbH, D-44227 Dortmund (DE)
(72) Erfinder: Reinecke, Holger, Dr., D-44287 Dortmund (DE); Rogner, Arnd, Dr., D-45549 Sprockhövel (DE); Nöker, Friedolin Franz, D-76133 Karlsruhe (DE); Sieber, Ulrich, Dr., D-76227 Karlsruhe (DE); Prüfer, Gerd, Dr., D-35614 Asslar (DE); Pannhoff, Helge, D-44229 Dortmund (DE); Brenk, Uwe, D-75236 Kämpfelbach (DE)

(56) Entgegenhaltungen:
- EP-A- 0 043 458
- EP-A- 0 253 066
- EP-A- 0 459 665
- US-A- 4 124 473
- IBM TECHNICAL DISCLOSURE BULLETIN, Bd.36, Nr.10, Oktober 1993, NEW YORK, US Seiten 423 - 424, XP000412432 ANONYMOUS 'Multilayer Circuit Fabrication using Double Exposure of Positive Resist'

## Beschreibung

Die Erfindung betrifft gestufte Formeinsätze, mit denen gestufte Mikrostrukturkörper hergestellt werden, und ein Verfahren zum Herstellen der gestuften Formeinsätze.

Die Erfindung bezweckt, gestufte Mikrostrukturkörper hoher Präzision auf wirtschaftliche Weise herzustellen.

Nach dem LIGA-Verfahren hergestellte Mikrostrukturkörper haben meist Mikrostrukturen mit lateralen Abmessungen im Mikrometer-Bereich bei einer Höhe, die mehrere hundert Mikrometer betragen kann. Im allgemeinen sind die Mikrostrukturkörper planar, d. h. die lateralen Abmessungen der Mikrostrukturen sind über die ganze Strukturhöhe praktisch konstant, und die Seitenwände der Mikrostrukturen sind parallel zueinander.

Für viele Anwendungen ist es erforderlich, räumliche Mikrostrukturen herzustellen, was aber bei diesem Verfahren mit paralleler Bestrahlung nur bedingt durch Schrägstellen der Probe zum Strahlengang möglich ist.

Räumliche Strukturen lassen sich in den meisten Fällen durch mehrere Ebenen planarer Strukturen mit unterschiedlicher Strukturhöhe erzeugen. Dieses kann erreicht werden durch z. B. stufigen Aufbau auf der Grundplatte.

Nach EP-184 608 lassen sich Körper mit säulenförmiger Mikrostruktur herstellen, die in zwei Bereichen unterschiedliche Höhen haben. Dazu wird eine Schicht eines durch Röntgenstrahlung in seinen Eigenschaften veränderbaren Kunststoffs (Resist-Material) zunächst mit Röntgenstrahlung durch eine strukturierte Maske hindurch partiell bestrahlt, wobei die Resistschicht in ihrer gesamten Dicke von der Röntgenstrahlung durchdrungen wird. Anschließend wird die Resistschicht erneut mit Röntgenstrahlung durch eine zweite strukturierte Maske hindurch partiell bestrahlt, wobei die Eindringtiefe der Strahlung geringer ist als die Dicke der Resistschicht und die bestrahlten Bereiche größer sind als bei der ersten Bestrahlung. Dieses Verfahren ist grundsätzlich geeignet, Mikrostrukturkörper mit mehr als zwei unterschiedlichen Strukturhöhen herzustellen. Für jede Strukturhöhe ist ein eigener Bestrahlungsschritt erforderlich. Für jeden Bestrahlungsschritt wird eine gesonderte Maske verwendet, die mit hoher Präzision relativ zu den bereits bestrahlten Bereichen der Resistschicht zu positionieren ist. Dadurch wird der Aufwand beträchtlich erhöht und die Ausbeute spürbar vermindert. Die genaue Stufenhöhe, eine glatte Stufenebene und eine exakte Rechtwinkligkeit zu den Seiten der Mikrostruktur ist schwierig einzustellen.

In EP-253 066 ist ein Verfahren zur Herstellung von Mikrostrukturkörpern mit Bereichen mit unterschiedlicher Strukturhöhe angegeben. Eine Resistschicht wird durch eine einzige Maske hindurch, deren Struktur der Struktur des Mikrostrukturkörpers entspricht (Absorberstruktur) einmalig bestrahlt (Röntgentiefenlithographie). Die Maske besteht aus einer strukturierten Schicht, die die Röntgenstrahlung fast vollständig absorbiert (Totalabsorberschicht), und mindestens einer weiteren strukturierten Schicht, die die Röntgenstrahlung nur teilweise absorbiert (Partialabsorberschicht). Das Resist-Material ist ein Kunststoff mit scharfer unterer Grenzdosis, z. B. Polymethyl-methacrylat. Für die Partialabsorberschichten werden Stoffe mit unterschiedlichem Absorptionsvermögen innerhalb des Wellenlängenbereiches der verwendeten Röntgenstrahlung verwendet. Die Art der Partialabsorber-Materialien, deren jeweilige Schichtdicke, das Spektrum der verwendeten Röntgenstrahlung und die Strahlungsdosis sind auf die gewünschten unterschiedlichen Strukturhöhen des Mikrostrukturkörpers abzustimmen. Dieses Verfahren erfordert umfangreiche Berechnungen.

Mit dem Verfahren nach EP-253 066 erhält man zwar einen Mikrostrukturkörper mit lateraler Präzision im Submikrometerbereich, die Strukturhöhe wir jedoch nur über die scharfe untere Grenzdosis des Kunststoffs und die Strahlungsdosis festgelegt. Die spektrale Verteilung der verwendeten Röntgenstrahlung und die Strahlungsdosis sind erfahrungsgemäß nicht hinreichend exakt erfaßbar. Die Strukturhöhe schwankt deshalb um einige Mikrometer um die berechnete Höhe.

In US-4 124 473 wird ein Verfahren zur Herstellung gestufter Strukturen, speziell optischer Gitter, durch reaktives Ionenätzen beschrieben. Die Strukturgenauigkeit liegt im SubmikrometerBereich bei typischen Strukturhöhen von einigen Mikrometern, z.B. 1,25 µm und 1,86 µm in einer 5 µm dicken SiO-Schicht. Die Ätzrate beträgt 0,02 bis 0,04 µm pro Minute. Zum Herstellen von Strukturen mit einer Höhe von einigen 10 µm bis einigen 100 µm erfordert dieses Verfahren lange Ätzzeiten. Mit zunehmender Höhe der Strukturen nimmt deren laterale Genauigkeit stark ab. Bei Strukturhöhen von 10 µm bis 500 µm liefert es Strukturkörper, die wegen ihrer geringen lateralen Genauigkeit nur noch begrenzt brauchbar sind.

In DE-41 42 001.2 ist die Herstellung von gestuften Formeinsätzen durch Kombination von mechanischer Präzisionsbearbeitung und Röntgenlithographie beschrieben. Bedingt durch die Bearbeitungsverfahren ist nur eine endliche Genauigkeit der Stufenabmessungen, insbesondere bezüglich der Stufenabfallfläche und der Stufenhöhe, von mehr als 10 Mikrometer erreichbar.

Damit stellt sich die Aufgabe, zunächst gestufte Formeinsätze hoher Präzision auf einfache Weise herzustellen, mit denen anschließend gestufte Mikrostrukturkörper hoher Präzision abgeformt werden können.

Diese Aufgabe wird erfindungsgemäß gelöst durch ein Verfahren mit den in Anspruch 1 angegebenen Merkmalen. Die ebene und planparallele Grundplatte besteht bevorzugt aus einem elektrisch leitfähigen Material, bevorzugt aus einem Metall wie Kupfer, Stahl, Aluminium, Titan, oder aus einem elektrisch nicht leitfähigen Material. Die leitfähige Grundplatte wird gegebenenfalls mit einer Resist-Haftschicht versehen, die nicht leitfähige Grundplatte wird gegebenenfalls mit einer Galvanik-Startschicht versehen. Auf die Grundplatte wird für eine zusätzliche Stufenebene - in einer in der Lithographie üblichen Weise - eine Resistschicht aufgebracht und durch eine mechanisch oder lithographisch hergestellte Maske hindurch bestrahlt. Die Struktur der Maske ist auf die Struktur der Zusatzebene abgestimmt.

Als Resist-Material wird entweder ein Positiv-Resist, z. B. Poly-methylmethacrylat (PMMA) (z. B. Plexit 60 der Fa. Röhm) oder ein Negativ-Resist (z. B. Ray-PN (AZ-PN) der Fa. Hoechst) verwendet.

Durch die Bestrahlung ändert sich die Löslichkeit des Resists. Bei einem Positiv-Resist sind die bestrahlten Bereiche leichter löslich als die unbestrahlten; bei einem Negativ-Resist ist es umgekehrt. Wegen dieses Löslichkeitsunterschiedes lassen sich die (bestrahlten oder unbestrahlten) leichter löslichen Bereiche des Resists mit einem Lösemittel selektiv auflösen. Die schwer löslichen Bereiche sind in einem stärkeren Lösemittel löslich. Die "Löslichkeit" des Resists bezieht sich auf die Einwirkung eines speziellen Lösemittels ("Entwicklers") bei den gewählten Lösebedingungen.

Nach dem Bestrahlen werden die leichter löslich gewordenen oder leichter löslich gebliebenen Bereiche der Resistschicht mit einem Lösemittel ("Entwickler") gelöst und entfernt. Für PMMA ist z. B. der GG-Entwickler nach DE-OS 30 39 110 geeignet; für den Negativ-Resist AZ-PN ist wäßrige Ammoniumhydroxid-Lösung als Entwickler geeignet.

Die Struktur der Zusatzebene ist damit in der Resistschicht bis auf die leitfähige Grundplatte oder die leitfähige Galvanik-Startschicht freigelegt.

Die Bereiche, aus denen das leichter lösliche Material der Resistschicht herausgelöst wurde, werden galvanisch oder chemisch mit Metall gefüllt; hierzu sind Gold, Nickel, Kupfer oder deren Legierungen geeignet. Die Dicke des abgeschiedenen Metalls ist bevorzugt etwas kleiner als die Dicke der Resistschicht. Die Dicke der galvanisch aufgetragenen strukturierten Metallschicht wird entweder durch den elektrischen Strom und die Dauer der Abscheidung des Metalls gesteuert, oder das zunächst etwas dicker abgeschiedene Metall wird - ebenso wie die stehengebliebenen Teile der Resistschicht - mechanisch auf die vorgegebene Dicke abgetragen.

Der Abstand dieser Zusatzfläche von der planen Oberfläche der Grundplatte und ihre Oberflächengüte werden mit einer Genauigkeit von ± 0,5 Mikrometer erreicht. Die stehengebliebenen schwerer löslichen Bereiche der Resistschicht werden mit einem stärkeren Lösemittel herausgelöst.

Weitere beliebig strukturierte Zusatzebenen können durch Wiederholen dieser Verfahrensschritte übereinandergelegt werden, wobei durch Lithographie mit justierten Masken eine Genauigkeit der Lage der einzelnen Ebenen zueinander im Mikrometerbereich erreicht werden kann.

Jede Resistschicht wird in ihrer gesamten Dicke bevorzugt durch jeweils eine einzige strukturierte Maske, z. B. mit Röntgenstrahlung, bestrahlt. Als Röntgenstrahlung wird bevorzugt die Synchrotron-Strahlung aus einem Elektronen-Synchrotron mit z. B. 2,3 GeV Elektronen-Energie verwendet. Die Maske wird zu der auf der Grundplatte bereits erzeugten Struktur justiert.

Auf die mit einer oder mehreren strukturierten Zusatzebenen versehenen Grundplatte wird die letzte Resistschicht über alle Stufen hinweg aufgebracht bis zu einer Dicke, die der Gesamthöhe des später abzuformenden Mikrostrukturkörpers entspricht. Die Oberfläche der letzten Resistschicht wird dazu erforderlichenfalls durch mechanische Präzisionsbearbeitung bis zur gewünschten Höhe - ebenfalls mit einer Genauigkeit im von ± 1 µm - abgetragen.

Die letzte Resistschicht wird durch eine letzte justiert angebrachte Maske hindurch bestrahlt, und die leichter löslichen Bereiche der letzten Resistschicht werden herausgelöst.

Anschließend wird in den Bereichen, aus denen die Resistschicht herausgelöst wurde, ein Metall z. B. galvanisch abgeschieden. Hierzu sind Gold, Nickel, Kupfer oder deren Legierungen geeignet. Nachdem die Struktur vollständig mit Metall gefüllt ist, wird weiteres Metall in einer zusammenhängenden bis mehrere Millimeter dicken Schicht z. B. galvanisch abgeschieden, um den Formeinsatz zusammenzuhalten und ihn für das spätere Abformen von Mikrostrukturkörpern hinreichend stabil zu machen; die mit Metall ausgefüllte Struktur wird also mit weiterem Metall überwachsen. Bei der Dicke der Überwachsungsschicht ist ein Kompromiß zwischen mechanischer Stabilität des Formeinsatzes und Zeitbedarf für das galvanische Abscheiden von Metall einzugehen.

Bei Bedarf wird die Außenkontur der galvanisch abgeschiedenen zusammenhängenden Metallschicht mechanisch bearbeitet.

Die Grundplatte wird - bevorzugt mechanisch - durch zerspanende Bearbeitung wie Fräsen oder Sägen abgetragen. Gegebenenfalls kann die Grundplatte auch abgerissen werden. Am günstigsten ist ein Abtragungsverfahren, bei dem keine Bearbeitungskräfte auftreten, wie z. B. Funkenerosion oder Ätzen. Auch Kombinationen verschiedener Abtragungsverfahren sind geeignet.

Gegebenenfalls werden die in Höhe der Grundplatten-Oberfläche befindlichen nach dem Abtragen der Grundplatte offenliegenden Bereiche des galvanisch abgeschiedenen Metalls mechanisch überarbeitet.

Anschließend werden die in dem galvanisch abgeschiedenen Metallkörper verbliebenen Teile der nicht leitfähigen und der leitfähigen Zwischenschichten entfernt. Hierzu kann nach dem Abtragen der Grundplatte die freigelegte Schicht beispielsweise mit einem Klebstoff übergossen werden, der nach dem Aushärten abgezogen wird und dabei die anhängenden Teile der zu entfernenden Schichten aus der Metallstruktur mitnimmt. Andererseits können die stehengebliebenen Teile der Resistschicht herausgelöst werden, gegebenenfalls nach einer Flutbestrahlung, und anschließend wird die Platte mit Klebstoff übergossen, der nach dem Aushärten abgezogen wird und dabei die anhängenden Teile der zu entfernenden Schichten aus der Metallstruktur mitnimmt. Weiter kann man die zu entfernenden Schichten selektiv herauslösen, wozu man Lösemittel verwendet, die wesentlich aggressiver sind als die vorher verwendeten "Entwickler"; außerdem kann man in diesem Fall die Lösetemperatur erhöhen.

Nachdem alle Stoffe aus der galvanisch abgeschiedenen Metallstruktur entfernt worden sind, liegt der fertige metallene Formeinsatz vor.

Mit Hilfe des gestuften Formeinsatzes werden nach bekannten Verfahren gestufte Mikrostrukturkörper aus Kunststoff abgeformt. Zum Abformen sind Kunststoffe wie Polymethyl-methacrylat, Poly-oxymethylen, Polycarbonat, Polyamid, wärmeformbeständige und/oder chemikalienresistente Kunststoffe wie z. B. Polyvinyliden-fluorid (PVDF) oder Polyether-etherketon (PEEK) sowie pulverförmige Sinterwerkstoffe geeignet, wobei letztere gegebenenfalls durch Zusatz eines Bindemittels plastisch verformbar gemacht werden. Die dadurch erzeugten zur Mikrostruktur des gestuften Formeinsatzes komplementären Mikrostrukturen aus Kunststoff oder Sinterwerkstoff lassen sich in bekannter Weise aus dem Formeinsatz entnehmen, womit man den gestuften Mikrostrukturkörper erhält. Der gestufte Formeinsatz kann zum wiederholten Abformen derartiger Mikrostrukturkörper verwendet werden.

Der abgeformte gestufte Mikrostrukturkörper kann unterschiedlich geformte und unterschiedlich oder gleich hohe Mikrostrukturen mit mindestens einer Stufe in einem einstückigen Körper und sich nahezu sprunghaft ändernde laterale Abmessungen, bezogen auf die Gesamthöhe des Mikrostrukturkörpers, haben.

Der abgeformte gestufte Mikrostrukturkörper kann aus Kunststoff, Keramik oder Sinterwerkstoff bestehen, wobei der gestufte Mikrostrukturkörper mechanisch abgeformt wird und anschließend aus dem Formeinsatz entnommen wird; der Formeinsatz kann wiederholt zum Abformen benutzt werden.

Der abgeformte gestufte Mikrostrukturkörper kann aus Metall bestehen, wobei der gestufte Mikrostrukturkörper galvanisch oder chemisch abgeformt wird und der Formeinsatz entformt oder (als verlorene Form) nach dem Abformen aufgelöst werden kann.

Metallene Formeinsätze mit geeigneter Mikrostruktur, z. B. mit konisch verlaufenden Wänden oder mit kleinem Aspektverhältnis, kann man in eine Komplementärstruktur umformen. Die Komplementärstruktur kann z. B. aus Kunststoff oder Metall bestehen. Für eine Komplementärstruktur aus Metall wird in einem Formeinsatz z. B. aus einem relativ unedlen Metall (wie Kupfer oder Nickel) ein relativ edles Metall (wie Gold oder Platin) galvanisch oder chemisch abgeschieden. Man kann entweder das relativ edle Metall nur bis zur Höhe der ehemals vorhandenen Oberfläche der Grundplatte abscheiden, oder man kann darüber hinaus weiteres relativ edles Metall in einer hinreichend dicken Schicht abscheiden und die Mikrostruktur überwachsen lassen. Der Formeinsatz kann von der Komplementärstruktur entformt werden; in diesem Fall kann der Formeinsatz wiederholt verwendet werden. Falls das Entformen nicht möglich ist, wird der Formeinsatz (als verlorene Form) nach dem Abformen aufgelöst.

Beim Abformen eines Mikrostrukturkörpers mittels des Formeinsatzes ist die Struktur des Mikrostrukturkörpers zur Struktur des Formeinsatzes komplementär. Beim Abformen eines Mikrostrukturkörpers mittels einer Komplementärstruktur stimmt die Struktur des Mikrostrukturkörpers mit der Struktur des Formeinsatzes überein.

Das beschriebene Verfahren umfaßt unter anderem alle Schritte des LIGA-Verfahrens.

Das erfindungsgemäße Verfahren, die damit hergestellten gestuften Formeinsätze und die abgeformten gestuften Mikrostrukturkörper haben folgende Vorteile:
- Die laterale Genauigkeit der röntgenlithographisch strukturierten Ebenen und die vertikale Genauigkeit der Stufenhöhe liegen im Submikrometer- bzw. im Mikrometerbereich.
- Die Lagegenauigkeit der einzelnen Ebenen zueinander liegt - je nach Justieraufwand - im Submikrometer- bis Mikrometerbereich.
- Der gestufte Formeinsatz ist überaus maBhaltig, weil er während aller Verfahrensschritte auf einer festen Grundplatte aufgebaut wird.
- Das Verfahren zum Herstellen des gestuften Formeinsatzes ist wenig anfällig gegen Fehler, und der Ausschußanteil bei der Fertigung ist gering.
- Die bei der späteren Abformung vorhandenen Oberflächen werden in der Resistschicht lithographisch erzeugt und haben bekanntermaßen eine äußerst geringe Rauhtiefe. Die durch mechanische Präzisionsbearbeitung erzeugten Grund- und Zusatzebenen haben bei Bearbeitung durch Polierfräsen ebenfalls eine geringe Rauhtiefe.
- Die Zusatzebenen werden im voraus hergestellt und sind in ihrer Höhenlage kontrollierbar und jeweils nachbearbeitbar, sowohl additiv durch weitere Metallabscheidung als auch subtraktiv durch Abarbeiten.
- Für die Obeflächenbearbeitung der zusätzlichen Ebenen auf der Grundplatte werden Maschinen mit hoher Reproduzierbarkeit und hoher Maßhaltigkeit eingesetzt.
- Der gestufte Formeinsatz wird ohne Unterbrechung durch galvanisches Abscheiden von Metall hergestellt.

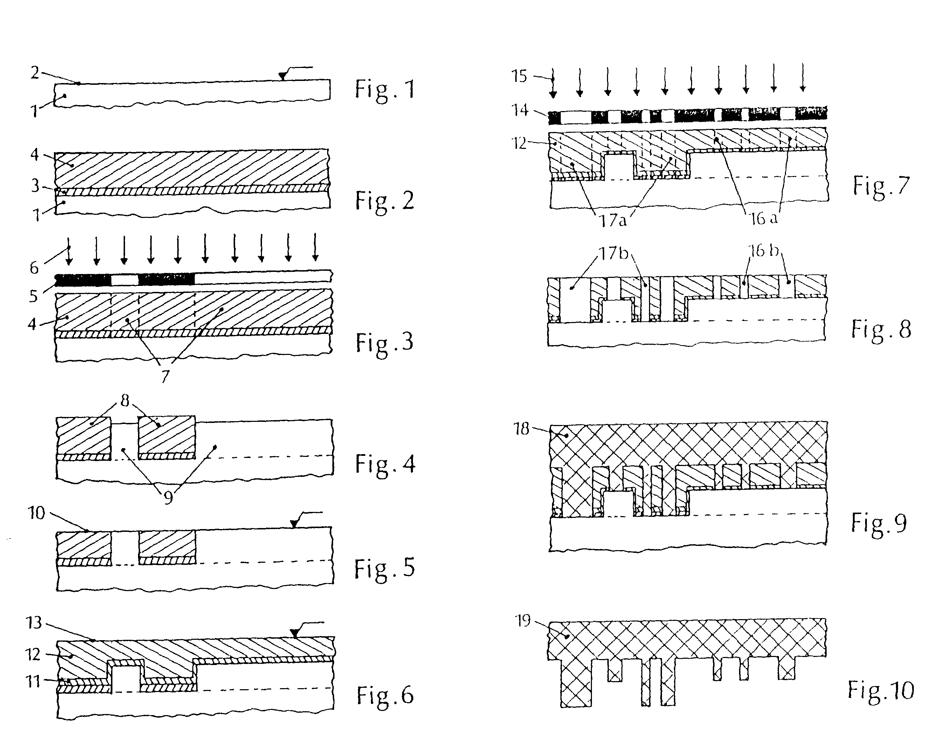

Die Erfindung wird an Hand der Figuren 1 bis 11 näher erläutert; die Figuren 1 bis 10 zeigen - jeweils im Querschnitt dargestellt - die Herstellung eines zweistufigen Formeinsatzes unter Verwendung eines Positiv-Resists.

Die Grundplatte (1) besteht aus Kupfer mit einer ebenen Oberfläche (2); die Kupferplatte kann auch eine zu ihrer Unterseite planparallele Oberfläche haben. Auf die Oberfläche (2) wird zunächst eine Haftschicht (3) aufgetragen und darüber eine Schicht (4) eines ersten Röntgenresists, z. B. aus Polymethyl-methacrylat. Die Schicht (4) ist dicker als die Höhe der vorgesehenen Stufe. Die z. B. durch Lithographie und Galvanoformung oder mechanisch hergestellte erste Röntgenmaske (5) hat gegen Röntgenstrahlung transparente Bereiche mit einer Struktur, die der gewünschten Struktur der höher liegenden Zusatzebene entspricht.

Die Resistschicht (4) wird durch die Röntgenmaske hindurch mit Synchrotron-strahlung (6) bestrahlt; dabei werden die bestrahlten Bereiche (7) der ersten Resistschicht löslich. Diese Bereiche werden herausgelöst. In den herausgelösten Bereichen der ersten Resistschicht wird Kupfer galvanisch abgeschieden. Die Kupferschicht (9) (siehe Figur 4) ist bevorzugt etwas dünner als die Dicke der stehengebliebenen ersten Resistschicht (8), jedoch etwas dicker als die gewünschte End-Dicke. Die Schicht aus Resist und Kupfer wird mittels einer Polier-Fräse auf die gewünschte Stufenhöhe (10) mit der vorgeschriebenen Genauigkeit, z. B. 0,5 µm, abgetragen (siehe Figur 5).

Die stehengebliebenen Teile (8) der ersten Resistschicht werden herausgelöst. Auf die strukturierte Kupferschicht und über die Haftschicht (3) hinweg wird eine weitere Haftschicht (11) sowie eine zweite (und in diesem Fall letzte) Resistschicht (12) aufgebracht. Die zweite Resistschicht (12) wird mit der vorgeschriebenen Genauigkeit, z. B. 1 µm, auf die gewünschte Höhe (13) mechanisch abgearbeitet.

Eine zweite (und in diesem Fall letzte) Röntgenmaske (14), die entsprechend der auf der ersten und der zweiten Ebene zu erzeugenden Struktur strukturiert ist, wird über der freien Seite der zweiten Resistschicht (12) justiert angeordnet. Die zweite Resistschicht (12) wird durch die zweite Maske (14) hindurch mit Synchrotronstrahlung (15) bestrahlt. Die löslich gewordenen Bereiche (16 a) oberhalb der zweiten Ebene und (17 a) oberhalb der ersten Ebene werden herausgelöst, wodurch Gräben (16 b) und (17 b) entsprechender Form und Größe entstehen.

Die Höhe der Gräben wird durch das Einbringen metallener Zwischenschichten eingestellt.

Die Gräben werden mit einem Metall (18), z. B. Nickel, ausgefüllt und mit einer Metallschicht überdeckt. Anschließend wird die Grundplatte einschließlich der Stufen (mechanisch und/oder chemisch) abgetragen und die Reste der Haftschichten sowie die Reste der zweiten Resistschicht (12) werden herausgelöst.

Mit dem mikrostrukturierten Metallkörper (19) (z. B. aus Nickel) als Formeinsatz werden Mikrostrukturkörper aus Kunststoff abgeformt. Die Genauigkeit dieser Mikrostrukturkörper liegt bei der Anordnung der Strukturen in den beiden Ebenen und im Abstand der Ebenen voneinander im Mikrometer- bis Submikrometerbereich. Die beim Abformen mit Kunststoffen auftretende Schwindung wird bei der Herstellung des Formeinsatzes berücksichtigt.

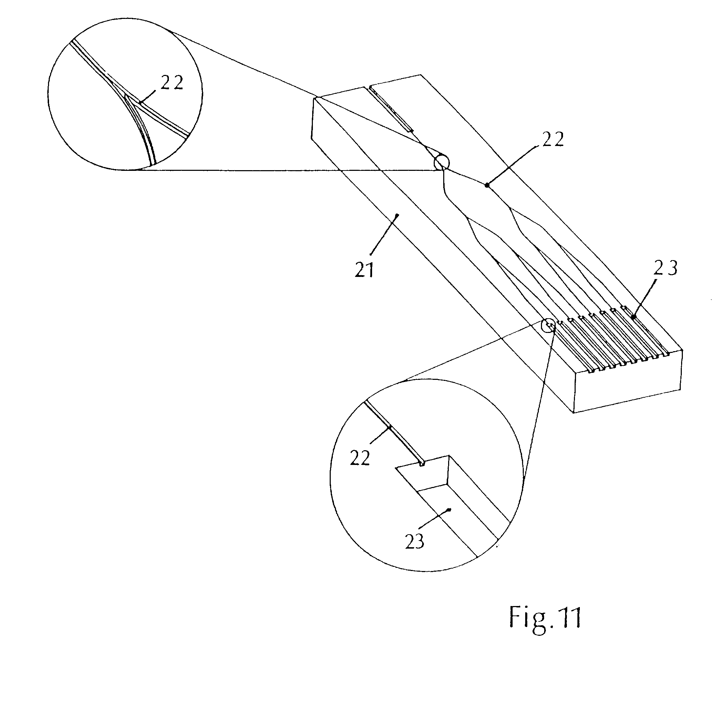

Figur 11 zeigt in Schrägansicht als Beispiel einen abgeformten Mikrostrukturkörper (21) aus Kunststoff mit zwei Stufen zur Herstellung eines 1 x 8-Kopplers für Lichtwellenleiter-Netze. In der oberen Ebene liegen die Gräben (22) als Vorformen für integriert-optische Wellenleiter. Diese sind z. B. 9 µm breit und 7 µm tief. In der unteren Ebene liegen die Führungsgräben (23), in die die Enden der anzukoppelnden Wellenleiter-Fasern präzise eingelegt und in denen diese Faserenden dauerhaft fixiert werden. Die Führungsgräben sind z. B. 66 µm tief, 125 µm breit und etwa 5 mm lang.

Der Abstand zwischen den beiden Ebenen - Sohle des Führungsgrabens bis Sohle des Wellenleiter-Vorform-Grabens - beträgt z. B. (59,0 ± 0,5) µm und kann mit dem erfindungsgemäßen Verfahrens präzise realisiert werden.

Die in der Mitte des Führungsgrabens senkrecht stehende Ebene ist gegen die in der Mitte des zugehörenden Wellenleiter-Vorform-Grabens senkrecht stehende Ebene um weniger als 0,5 µm versetzt.

Einzelheiten zur Herstellung solcher integriert-optischer Bauelemente sind z. B. in DE-42 17 526.7 angegeben.

## Patentansprüche

1. Verfahren zum Herstellen gestufter Formeinsätze mit lateraler und vertikaler Genauigkeit im Submikrometerbereich, gekennzeichnet durch
- Aufbringen einer ersten Resistschicht, die höher als die vorgesehene Stufe ist, auf eine ebene und planparallele Grundplatte,
- Bestrahlen der ersten Resistschicht durch eine erste strukturierte Maske hindurch,
- Auflösen der leichter löslichen Bereiche der ersten Resistschicht,
- Abscheiden von Metall in den Bereichen, aus denen das leichter lösliche Material der ersten Resistschicht herausgelöst wurde, bis zu einer vorgegebenen Höhe,
- Herauslösen der schwerer löslichen Bereiche der ersten Resistschicht,
- Aufbringen einer letzten Resistschicht über alle Stufen hinweg,
- Bestrahlen der letzten Resistschicht durch eine letzte justiert angebrachte Maske hindurch,
- Auflösen der leichter löslichen Bereiche der letzten Resistschicht,
- Abscheiden von Metall in den Bereichen, aus denen das leichter lösliche Material der letzten Resistschicht herausgelöst wurde,
- Überdecken aller Bereiche mit Metall in einer bis zu mehreren Millimetern dicken Schicht,
- Abtragen der Grundplatte und Beseitigen der Reste der letzten Resistschicht.

2. Verfahren nach Anspruch 1, gekennzeichnet durch
- Aufbringen der ersten Resistschicht auf eine leitfähige Grundplatte, die gegebenenfalls vorher mit einer Haftschicht für die erste Resistschicht versehen wird.

3. Verfahren nach Anspruch 1, gekennzeichnet durch
- Aufbringen der ersten Resistschicht auf eine nicht leitfähige Grundplatte, die vorher mit einer Galvanikstartschicht versehen wird.

4. Verfahren nach den Ansprüchen 1 bis 3, gekennzeichnet durch
- galvanisches Abscheiden von Metall in den Bereichen, aus denen das leichter lösliche Material der ersten Resistschicht herausgelöst wurde, bis zu der vorgegebenen Höhe durch Strom- und Zeitsteuerung.

5. Verfahren nach den Ansprüchen 1 bis 3, gekennzeichnet durch
- galvanisches oder chemisches Abscheiden von Metall in den Bereichen, aus denen das leichter lösliche Material der ersten Resistschicht herausgelöst wurde, auf eine Höhe, die größer als die vorgegebene Höhe ist, und mechanisches Abtragen von Metall und Resistmaterial bis zu der vorgegebenen Höhe.

6. Verfahren nach den Ansprüchen 1 bis 5, gekennzeichnet durch
- Aufbringen einer Resist-Haftschicht und/oder Galvanik-Startschicht über alle Stufen hinweg, bevor eine weitere Resistschicht aufgebracht wird.

7. Verfahren nach Anspruch 1 zum Herstellen mehrfach gestufter Formeinsätze, gekennzeichnet durch
- wiederholtes Ausführen der ersten fünf Verfahrensschritte nach Anspruch 1, wobei für das Bestrahlen der jeweiligen Resistschicht jeweils nur eine strukturierte Maske benutzt wird,
- einmaliges Ausführen der letzten sechs Verfahrensschritte nach Anspruch 1.

8. Gestufter Formeinsatz mit lateraler und vertikaler Genauigkeit im Submikrometerbereich, hergestellt nach dem Verfahren nach den Ansprüchen 1 bis 7.

9. Gestufter Mikrostrukturkörper mit lateraler und vertikaler Genauigkeit im Submikrometerbereich, hergestellt durch Abformen mittels eines gestuften Formeinsatzes nach Anspruch 8, gekennzeichnet durch
- unterschiedlich geformte und unterschiedlich oder gleich hohe Mikrostrukturen mit mindestens einer Stufe in einem einstückigen Körper, und
- sich nahezu sprunghaft ändernde laterale Abmessungen, bezogen auf die Gesamthöhe des Mikrostrukturkörpers.

10. Gestufter Mikrostrukturkörper nach Anspruch 9 aus Kunststoff, Keramik oder Sinterwerkstoff, wobei
- der gestufte Mikrostrukturkörper mechanisch abgeformt wird, und
- der Mikrostrukturkörper aus dem Formeinsatz entnommen wird, und
- der Formeinsatz wiederholt zum Abformen benutzt wird.

11. Gestufter Mikrostrukturkörper nach Anspruch 9 aus Metall, wobei
- der gestufte Mikrostrukturkörper durch galvanisch oder chemisch abgeschiedenes Metall gebildet wird, und
- der Formeinsatz nach dem Abscheiden entformt oder aufgelöst wird und der metallene Mikrostrukturkörper erhalten wird.

12. Gestufter Mikrostrukturkörper nach Anspruch 9 aus Kunststoff, Keramik, Sinterwerkstoff oder Metall, wobei
- der gestufte Formeinsatz durch Abformen in eine Komplementärstruktur umgeformt wird,
- der gestufte Mikrostrukturkörper mechanisch, galvanisch, chemisch oder mittels der Pulvertechnik in der Komplementärstruktur gebildet wird,
- die Komplementärstruktur entformt oder aufgelöst wird und der Mikrostrukturkörper erhalten wird.

## Claims

1. A method of producing stepped mould inserts having lateral and vertical precision in the submicrometre region, characterized by
- application of a first resist layer which is higher than the step envisaged to a flat and plane-parallel baseplate,
- irradiation of the first resist layer through a first patterned mask,
- dissolution of the more readily soluble regions of the first resist layer,
- deposition of metal in the regions out of which the more readily soluble material of the first resist layer has been dissolved until a predetermined height is reached,
- dissolving out of the sparingly soluble regions of the first resist layer,
- application of a final resist layer over all the steps,
- irridation of the final resist layer through a final mask applied in an. aligned manner,
- dissolution of the more readily soluble regions of the final resist layer,
- deposition of metals in the regions out of which the more readily soluble material of the final resist layer has been dissolved,
- covering of all the regions with metal in a layer up to several millimetres thick,
- removal of the baseplate and removal of the residues of the final resist layer.

2. A method according to claim 1, characterized by
- application of the first resist layer to a conductive baseplate which is provided beforehand, if desired, with an adhesion layer for the first resist layer.

3. A method according to claim 1, characterized by
- application of the first resist layer to a nonconductive baseplate which is provided beforehand with an electroplating starter layer.

4. A method according to any of claims 1 to 3, characterized by
- electrodeposition of metal in the regions out of which the more readily soluble material of the first resist layer has been dissolved until the predetermined height is reached by current and time control.

5. A method according to any of claims 1 to 3, characterized by
- electrodeposition or electroless deposition of metal in the regions out of which the more readily soluble metal of the first resist layer has been dissolved to a height which is greater than the predetermined height, and mechanical removal of metal and resist material down to the predetermined height.

6. A method according to any of claims 1 to 5, characterized by
- application of a resist adhesion layer and/or electroplating starter layer over all the steps before a further resist layer is applied.

7. A method according to claim 1 for producing multiply stepped mould inserts, characterized by
- repeated performance of the first five method steps according to claim 1, a single patterned mask being used for the irradiation of the respective resist layer in each case,
- one-off performance of the final six method steps according to claim 1.

8. A stepped mould insert having lateral and vertical precision in the submicrometre region produced by the method according to any of claims 1 to 7.

9. A stepped microstructure body having lateral and vertical precision in the submicrometre region, produced by moulding by means of a stepped mould insert according to claim 8, characterized by
- differently moulded microstructures having different or equal height and having at least one step in a one-piece body, and
- lateral dimensions which change virtually abruptly, relative to the overall height of the microstructure body.

10. A stepped microstructure body according to claim 9 of plastic, ceramic or sintered material, in which
- the stepped microstructure body is mechanically moulded, and
- the microstructure body is removed from the mould insert, and
- the mould insert is repeatedly used for moulding.

11. A stepped metal microstructure body according to claim 9, in which
- the stepped microstructure body is formed by electrodeposited or electrolessly deposited metal, and
- the mould insert is de-moulded after the deposition or is dissolved and the metallic microstructure body is obtained.

12. A stepped microstructure body according to claim 9 of plastic, ceramic, sintered material or metal, in which
- the stepped mould insert is transformed into a complementary structure by moulding,
- the stepped microstructure body is formed mechanically, by electrodeposition, by electroless deposition or by means of powder technology in the complementary structure,
- the complementary structure is de-moulded or is dissolved and the microstructure body is obtained.

## Revendications

1. Procédé de fabrication d'insert de moule étagé avec une précision latérale et verticale inférieure au micron,
caractérisé en ce que
- on applique une première couche de résiste plus épaisse que l'étage prévu sur la plaque de base plane parallèle et lisse,
- on irradie la première couche de résiste à travers un premier masque structuré,
- on dissout les zones facilement solubles de la première couche de résiste,
- on dépose du métal dans les zones dont on a dissout la matière facilement soluble de la première couche de résiste jusqu'à atteindre une hauteur prédéterminée,
- on dissout les zones difficilement solubles de la première couche de résiste,
- on applique une dernière couche de résiste par-dessus tous les étages,
- on irradie la dernière couche de résiste à travers un dernier masque, ajusté,
- on dissout les zones plus facilement solubles de la dernière couche de résiste,
- on dépose le métal dans les zones dont on a dissout la matière plus facilement soluble de la dernière couche de résiste,
- on recouvre toutes les zones avec du métal suivant une couche d'une épaisseur allant jusqu'à plusieurs millimètres,
- on enlève la plaque de base et les résidus de la dernière couche de résiste.

2. Procédé selon la revendication 1,
caractérisé en ce qu'
- on applique la première couche de résiste sur une plaque de base conductrice qui est le cas échéant préalablement munie d'une première couche d'accrochage pour la première couche de résiste

3. Procédé selon la revendication 1,
caractérisé en ce qu'
- on applique la première couche de résiste sur une plaque de base non conductrice préalablement munie d'une couche de démarrage galvanique.

4. Procédé selon les revendications 1 à 3,
caractérisé en ce qu'
- on dépose par voie galvanique du métal dans les zones dont on a dissout la matière plus facilement soluble de la première couche de résiste jusqu'à la hauteur prédéterminée en réglant l'intensité du courant et la durée.

5. Procédé selon les revendications 1 à 3,
caractérisé par,
- un dépôt galvanique ou chimique de métal dans les zones dont on a dissout la matière facilement soluble de la première couche de résiste jusqu'à une hauteur supérieure à la hauteur prédéterminée et on enlève mécaniquement du métal et du résiste jusqu'à la hauteur prédéterminée.

6. Procédé selon les revendications 1 à 5,
caractérisé en ce qu'
- on applique une couche d'accrochage de résiste et/ou une couche de démarrage galvanique sur tous les étages avant d'appliquer une autre couche de résiste.

7. Procédé selon la revendication 1 pour la fabrication d'insert de moule à étages multiples,
caractérisé en ce qu'
- on exécute de manière répétée les cinq premières étapes de procédé selon la revendication 1 et pour l'irradiation de la couche de résiste respective on utilise seulement un masque structuré,
- on réalise en une fois les six dernières étapes du procédé selon la revendication 1.

8. Insert de moule étagé à précision latérale et verticale inférieure au micron, fabriqué selon le procédé des revendications 1 à 7.

9. Corps à microstructures étagé ayant une précision latérale et verticale inférieure au micron, fabriqué par moulage à l'aide d'un insert de moule étagé selon la revendication 8,
caractérisé par
- des microstructures de forme différente et de hauteur différente ou égale avec au moins un étage dans un corps en une seule pièce et,
- des dimensions latérales qui varient pratiquement de façon discontinue par rapport à la hauteur totale du corps à microstructures.

10. Corps à microstructures étagé selon la revendication 9 en matière plastique, céramique ou matière frittée, selon lequel,
- on moule mécaniquement le corps à microstructures étagé et,
- on extrait le corps à microstructures de l'insert de moule et,
- on utilise l'insert de moule de manière répétée pour effectuer des moulages.

11. Corps à microstructures étagé selon la revendication 9 en métal selon lequel,
- on forme le corps à microstructures étagé avec un métal déposé par voie galvanique ou chimique et,
- on démoule ou on dissout l'insert de moule après le dépôt et on obtient le corps à microstructures, métallique.

12. Corps à microstructures étagé selon la revendication 9 en matière plastique, céramique, matière frittée ou métal selon lequel,
- on convertit l'insert de moule étagé par moulage pour obtenir une structure complémentaire,
- on forme le corps à microstructures étagés, par voie mécanique, galvanique, chimique ou par la technique des poudres pour obtenir une structure complémentaire,
- on démoule la structure complémentaire ou on la dissout et on obtient le corps à microstructures.
